(19) Europäisches Patentamt

European Patent Office

Office européen des brevets

(11) **EP 1 290 456 B1**

(12) **FASCICULE DE BREVET EUROPEEN**

(45) Date de publication et mention
de la délivrance du brevet:
**14.06.2006 Bulletin 2006/24**

(51) Int Cl.:
***G01R 31/02*** *(2006.01)*     ***H02H 3/16*** *(2006.01)*

(21) Numéro de dépôt: **01940631.3**

(22) Date de dépôt: **29.05.2001**

(86) Numéro de dépôt international:
**PCT/FR2001/001669**

(87) Numéro de publication internationale:
**WO 2001/096889 (20.12.2001 Gazette 2001/51)**

(54) **PROCEDE DE DETECTION DE DEFAUTS RESISTANTS**

VERFAHREN ZUR DETEKTION VON WIDERSTANDSBEHAFTETEN FEHLERN

METHOD FOR DETECTING RESISTIVE FAULTS

(84) Etats contractants désignés:
**AT BE CH CY DE DK ES FI FR GB GR IE IT LI LU
MC NL PT SE TR**

(30) Priorité: **13.06.2000 FR 0007524**

(43) Date de publication de la demande:
**12.03.2003 Bulletin 2003/11**

(73) Titulaire: **Electricité de France Service National
75008 Paris (FR)**

(72) Inventeur: **CHILARD, Olivier
F-92260 Fontenay-aux-Roses (FR)**

(74) Mandataire: **Fréchède, Michel et al
Cabinet Lavoix
2 Place d'Estienne d'Orves
75441 Paris Cedex 09 (FR)**

(56) Documents cités:
**EP-A- 0 537 066          WO-A-96/27138
DE-A- 4 418 124**

## Description

La présente invention concerne les réseaux de distribution d'énergie électrique polyphasée et se rapporte plus particulièrement à un procédé de détection de défauts résistants dans une ligne de départ d'un tel réseau.

Plus spécifiquement, elle porte sur un procédé de détection d'un défaut résistant sur un réseau de distribution à moyenne tension, c'est à dire un réseau dans lequel la tension présente sur les lignes de distribution alimentées par un poste d'alimentation du réseau se situe entre environ 1000 et 50000 Volt.

La détection des défauts résistants, ou résistifs, constitue un élément important pour la sécurité des tiers ou pour préserver l'environnement.

Pour cela, les exploitants des réseaux mixtes de distribution souhaitent généralement limiter la valeur des courants de défaut ; c'est-à-dire les courants circulent dans une ligne défectueuse, à 40 ampères en utilisant un régime de neutre compensé.

Dans les réseaux compensés, le neutre du réseau est relié à la terre par une bobine de compensation, également appelée bobine de « Petersen ». Cette bobine permet de minimiser le courant engendré en présence d'un défaut. En effet, il est possible, en agissant sur la valeur de l'inductance de la bobine de modifier le courant « réactif » circulant dans cette dernière, de manière à compenser le courant « capacitif » du réseau qui circule dans la résistance équivalente du défaut entre la phase défectueuse et la terre du réseau.

Ce type de mise à la terre du neutre du réseau permet par conséquent de limiter le courant de défaut.

Or, les dispositifs de protection contre les défauts résistants utilisés généralement sur les réseaux à régime de neutre de type impédant, ne fonctionnent plus correctement en régime de neutre compensé.

Dans ce type de réseau, c'est à dire dans les réseaux à neutre compensé, parmi les protections existantes, seul un relais à seuil de tension homopolaire ou de courant de neutre peut être utilisé. Cependant, du fait des propriétés du neutre compensé, la sensibilité d'une telle protection est limitée à quelque KΩ. De plus, ce type de protection n'est pas sélectif.

On a tenté de pallier ces inconvénients en réalisant une détection des défauts résistants à partir d'une comparaison vectorielle des courants résiduels circulant dans chaque ligne de départ du réseau de distribution. Cette comparaison s'effectue en prenant une référence de phase construite à partir de la somme des courants résiduels de l'ensemble des lignes de départ. EP 0 537 066 A1 décrit un exemple de ce type de détection.

Cette technique, bien qu'étant d'une efficacité accrue, présente une sensibilité toujours insuffisante. Elle impose en outre de prévoir une protection unique pour tout le poste source d'alimentation.

Le but de l'invention est de pallier ces inconvénients et de fournir un procédé de détection de défauts résistants dans un réseau compensé de grande sensibilité et dans lequel les risques de fonctionnement intempestif du dispositif de protection sont éliminés.

Elle a donc pour objet un procédé de détection de défauts résistants dans une ligne de départ d'un réseau de distribution d'énergie électrique doté d'une bobine de compensation, à partir d'une mesure du courant résiduel circulant dans cette ligne, caractérisé en ce qu'il comporte les étapes consistant à :

a) déterminer la phase de la tension homopolaire d'un jeu de barres alimentant la ligne de départ,

b) élaborer, à partir de la phase de la tension homopolaire, un plan complexe,

c) délimiter, dans le plan complexe, des zones de fonctionnement correspondant à une détection d'un défaut résistant et à une absence de détection d'un défaut,

d) positionner, dans le plan complexe, un point de fonctionnement de la ligne de départ, défini à partir du courant résiduel mesuré, et

e) analyser le régime de fonctionnement du réseau pour décider si la coïncidence entre le point de fonctionnement et une zone de détection correspond à une détection d'un défaut.

Ce procédé de détection peut en outre comporter une ou plusieurs des caractéristiques suivantes, prises isolément ou selon toutes les combinaisons techniquement possibles :

- la phase de la tension homopolaire est élaborée à partir d'une mesure des variations du courant de neutre du réseau et de la tension homopolaire,

- les grandeurs mesurées du réseau sont mesurées en utilisant des fenêtres temporelles glissantes de durée et de période égales à l'inverse de la fréquence de l'énergie électrique fournie par le réseau,

- les grandeurs mesurées sont acquises dans des fenêtres temporelles correspondant à un régime de fonctionnement permanent du réseau et situées de part et d'autre d'une plage de fonctionnement en régime transitoire,

- au cours de l'analyse du régime de fonctionnement du réseau, on détermine si le réseau se situe en régime transitoire ou en régime permanent, pour décider, d'une part, que si le régime est permanent, une coïncidence entre le point de fonctionnement et la zone de détection correspond à une détection d'un défaut et, d'autre part, lorsque la détection est réalisée, si le régime devient transitoire, ou si le point de fonctionnement quitte la zone de détection, la détection du défaut est maintenue pendant une période de temps prédéterminée, et que si à l'issue de cette période de temps, le régime du réseau est transitoire ou le point de fonctionnement se situe en dehors de la zone de détection, la détection n'est plus maintenue,

- le régime de fonctionnement du réseau est déterminé à partir d'un calcul de la dérivée de la tension homopolaire et comparaison de la dérivée calculée avec des seuils de détection de régime permanent et de régime transitoire,
- l'axe des réels du plan complexe correspond au vecteur de la tension homopolaire déduit de l'axe des imaginaires, l'axe des imaginaires du plan complexe correspondant au vecteur du courant de neutre décalé d'un angle élaboré à partir du déphasage entre la variation du courant de neutre et de la tension homopolaire entre deux mesures acquises pendant le régime de fonctionnement permanent encadrant un régime de fonctionnement transitoire;
- la zone de détection est délimitée par deux droites dont les coordonnées x, $y_1$ et x, $y_2$, sont respectivement déterminées par les relations :

$$y_1 = -\frac{x + seuil}{tg(\theta)}$$

$$y_2 = \frac{x - seuil}{tg(\theta)}$$

dans lesquelles :

seuil représente un seuil de protection ; et
θ représente une valeur de compensation d'erreurs de mesure,
et par une portion de cercle de rayon égal au seuil de protection,

- l'axe des imaginaires du plan complexe est en phase avec le vecteur représentatif du courant de neutre,
- la zone de détection est délimitée par deux droites dont les coordonnées x, $y_1$ et x, y2 sont respectivement définies par les relations suivantes :

$$y_1 = -\frac{x + seuil}{tg(\theta - \alpha)}$$

$$y_2 = \frac{x - seuil}{tg(\theta + \alpha)}$$

dans lesquelles :

seuil représente un seuil de protection,
θ représente une valeur de compensation d'erreurs de mesure, et
α représente le déphasage entre l'axe des réelles et la tension homopolaire théorique,
et par une portion de cercle de rayon égal au seuil de protection.

D'autres caractéristiques et avantages ressortiront de la description suivante, donnée uniquement à titre d'exemple, et faite en référence aux dessins annexés sur lesquels :

- la figure 1 représente le circuit équivalent d'un réseau de distribution d'énergie électrique triphasée équipé d'un dispositif de détection de défauts ;
- la figure 2 représente le plan complexe utilisé pour la détection des défauts résistants ;
- la figure 3 est un organigramme illustrant le principe du calcul du plan complexe de la figure 2 ;
- la figure 4 est un organigramme détaillant le principe de calcul de l'angle servant à l'élaboration de l'axe des imaginaires du plan complexe, et
- la figure 5 est un schéma représentant un plan complexe de secours utilisé lorsque le plan complexe de la figure 2 n'est pas déterminable.

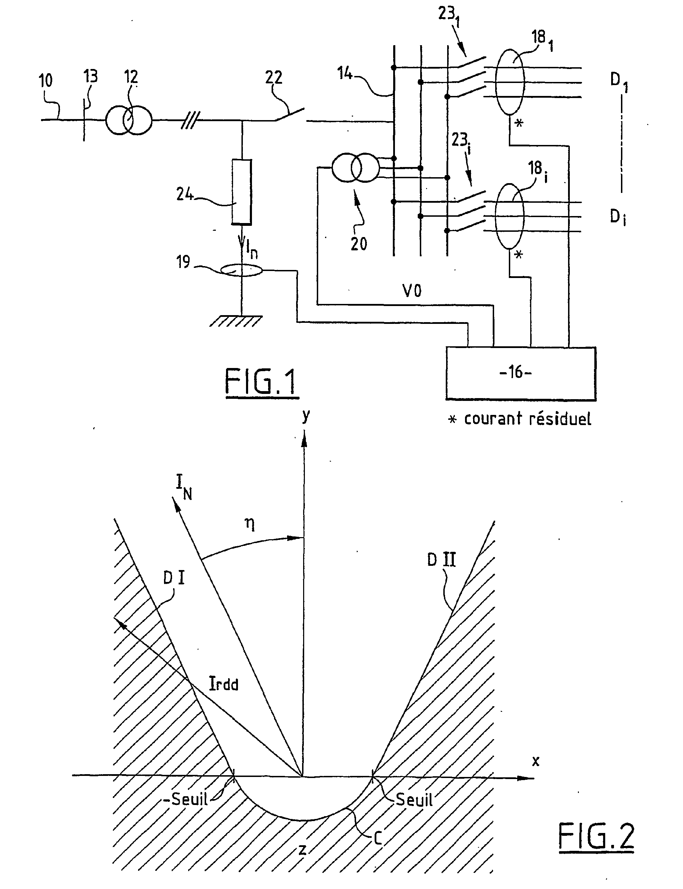

La figure 1 représente le circuit équivalent d'une portion d'un réseau de distribution d'énergie électrique triphasée, en particulier à moyenne tension (MT), c'est à dire une tension comprise entre 1000 et 50000 volts.

Comme on le voit sur cette figure, le réseau comporte un ensemble de lignes de transport 10, dont une seule est représentée sur cette figure, alimentant un transformateur 12 HT/MT via un jeu de barres à haute tension 13. Le transformateur 12 HT/MT alimente lui-même un jeu de barres MT, telles que 14, auquel est relié un ensemble de lignes de départ du réseau $D_1$, ..., $D_i$.

Le réseau est doté d'un dispositif 16 de détection de défauts, associé à des organes $18_1$, ..., $18_i$, 19 et 20 de mesure de grandeurs électriques caractéristiques de la présence d'un défaut.

Un ensemble de dispositifs de protection, constitués par des disjoncteurs, tels que $23_1$, ..., $23_i$ sont pilotés par le dispositif de détection 16 dès détection d'un défaut de mise à la terre sur l'une des phases du réseau.

Le neutre du réseau est raccordé à la terre par l'intermédiaire d'une bobine de compensation 24.

On notera que le réseau comporte, de préférence, des disjoncteurs additionnels (non représentés) pour isoler une portion du réseau défaillante.

Pour procéder à la détection d'un défaut résistant sur l'une des lignes de départ, le dispositif de détection 16 procède à l'acquisition périodique de la valeur du courant résiduel des lignes de départ $D_1$, ..., $D_i$ surveillées, de la valeur du courant de neutre $I_N$ circulant dans la bobine de compensation 24 et de la tension homopolaire $V_o$ du jeu de barres 14 alimentant la ligne de départ.

Ces valeurs sont acquises sous la forme de grandeurs complexes, à une période égale à l'inverse de la fréquence $f_i$ industrielle du réseau et pendant des durées égales à l'inverse de cette fréquence $f_i$.

Comme cela sera décrit en détail par la suite, ceci est réalisé en effectuant une transformée de Fourrier appliquée sur une fenêtre glissante de largeur $1/f_i$ secondes avec une période de $1/f_i$ secondes.

Pour réaliser la détection d'un défaut résistant, le dispositif de détection 16 observe l'évolution de la valeur du courant résiduel mesuré et procède à une analyse de cette évolution dans un plan complexe élaboré principalement à partir de la tension homopolaire $V_o$ mesurée.

Plus spécifiquement, le dispositif de détection 16 procède à une observation de l'évolution du lieu du vecteur représentatif de l'expression complexe du courant résiduel du départ protégé dans ce plan complexe.

Pour effectuer une détection, on positionne le point de fonctionnement de la ligne de départ, définie à partir du courant résiduel mesuré, et l'on détermine si ce point de fonctionnement coïncide avec une zone de détection d'un défaut.

A partir de cette détermination, et en fonction du régime de fonctionnement du réseau, le dispositif de détection 16 décide alors si cette coïncidence correspond ou non à l'apparition d'un défaut résistant, pour ensuite provoquer l'actionnement des dispositifs de protection.

Il procède en effet à une détection préalable du régime de fonctionnement, permanent ou transitoire.

Pour ce faire, le dispositif de détection 16 procède à un calcul de la dérivée par rapport au temps de la tension homopolaire $V_o$, selon la relation suivante :

$$\frac{d}{dt} V_o = (V_{o_n} - V_{o_{n-1}}) f_i \qquad (1)$$

dans laquelle :

- $V_{o_n}$ désigne l'expression complexe de la tension homopolaire à la fréquence industrielle $f_i$ pour la fenêtre d'acquisition n ; et
- $V_{o_{n-1}}$ désigne l'expression complexe de la tension homopolaire à la fréquence industrielle $f_i$ pour la fenêtre d'acquisition précédente n-1.

Cette dérivée est alors comparée avec deux valeurs de seuil Sp et St représentant des valeurs de seuil de détection de régime permanent et de régime transitoire, respectivement.

Ainsi, le régime de fonctionnement du réseau est permanent lorsque la valeur absolue de l'expression de la dérivée de la tension homopolaire est inférieure à la valeur de seuil Sp et le régime de fonctionnement du réseau est transitoire lorsque la valeur absolue de cette expression est supérieure à la valeur de seuil St.

On décide alors que si le vecteur représentatif de l'expression complexe du courant résiduel circulant dans un départ D1... Di à protéger se situe dans la zone de détection de défaut, alors que le réseau fonctionne en régime permanent, cette coïncidence entre le point de fonctionnement et la zone de détection correspond à une détection d'un défaut.

Par contre, lorsqu'une détection est réalisée si le régime de fonctionnement passe du régime permanent en régime transitoire ou si le point de fonctionnement quitte la zone de détection, on décide de maintenir la détection pendant une période de temps prédéterminée.

Enfin, à l'expiration de cette période de temps prédéterminée, si le vecteur représentatif de l'expression complexe du courant résiduel est en dehors de la zone de détection, ou si le régime de fonctionnement est toujours transitoire, l'on décide que le défaut est considéré comme non détecté (retombé de la détection).

La période de temps prédéterminée constitue un temps de maintien de la ou des sorties de détection de défaut du dispositif. Elle est de préférence réglable, par exemple réglable de 100 à 600 ms par pas de 10 ms.

On notera que les seuils de détection Sp et St de régime de fonctionnement permanent et transitoire sont des valeurs de seuil réglables. Pour un réseau à régime de neutre compensé, ces valeurs sont exprimées sous la forme d'un pourcentage de la tension nominale simple du réseau et correspondent, par exemple, respectivement à 1,8% et 3,6% de cette tension.

La définition du plan complexe permettant la détection d'un défaut va maintenant être décrite en référence aux figures 2 à 4.

En se référant tout d'abord à la figure 2, l'axe des réels x du plan complexe est confondu avec le vecteur représentatif de la tension homopolaire.

Pour s'affranchir d'une mesure directe de la phase de la tension homopolaire, qui serait trop imprécise, cette phase est déterminée à partir de l'observation des variations obtenues sur la mesure du courant de neutre $I_N$ et de la tension homopolaire $V_o$ lors, par exemple, de l'apparition d'un défaut ou au cours d'une procédure d'injection provoquée par un système d'accord.

L'axe des imaginaires y est, quant à lui, retardé de η degrés par rapport au vecteur représentatif du courant de neutre $I_N$ mesuré. Cet angle η représente, en pratique, le déphasage entre $I_N$ et la quadrature à la tension homopolaire présente au niveau du jeu de barres.

Ainsi, on calcule le retard η à appliquer à $I_N$ pour que l'axe des réels x en quadrature avec l'axe des imaginaires soit en phase avec la tension homopolaire théorique.

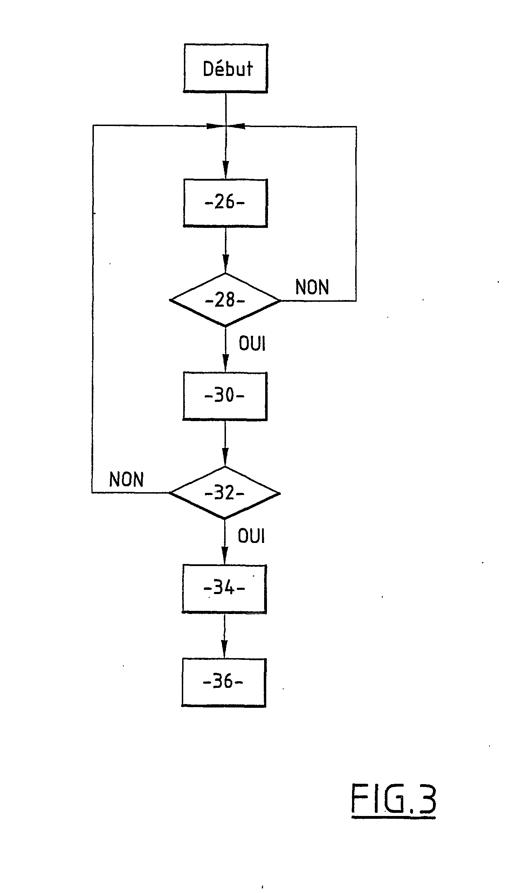

Cet angle de déphasage est calculé à partir des variations des valeurs complexes de la tension homopolaire $\Delta V_o$ et du courant de neutre $\Delta I_N$ entre deux instants d'acquisition au cours desquels le réseau se situe en régime de fonctionnement permanent encadrant un régime de fonctionnement transitoire, comme cela va maintenant être décrit en référence à la figure 3.

Cette procédure de calcul de l'angle η débute par une première phase 26 au cours de laquelle deux fenêtres $F_d$ et $F_f$ dites de début et de fin d'acquisition sont récupérées.

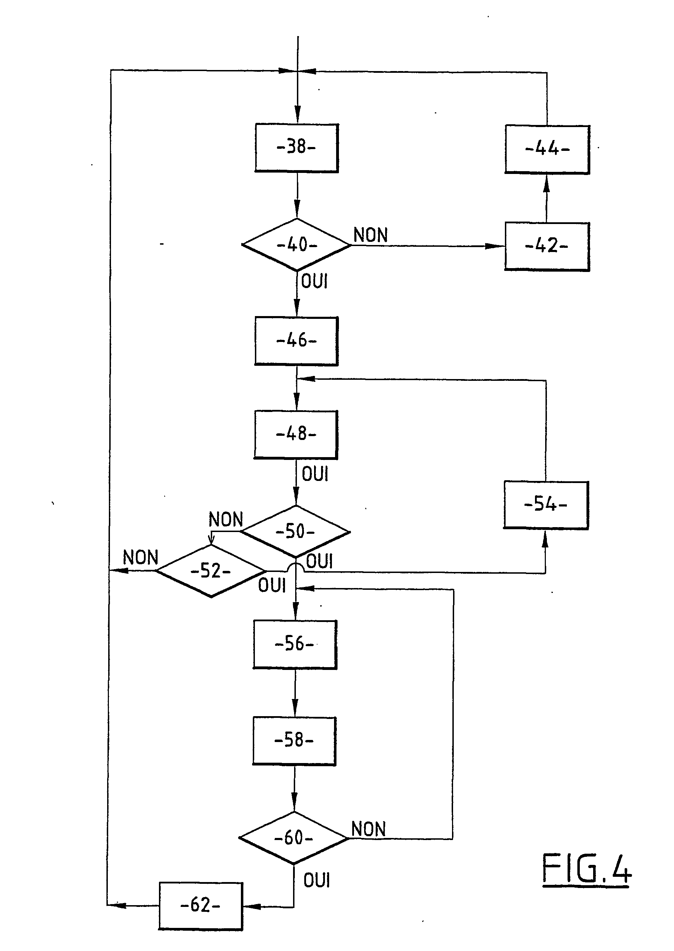

Comme cela sera décrit en référence à la figure 4, ces deux fenêtres correspondent à deux fenêtres d'acquisition des données issues des organes de mesure 19 et 20 lorsque le réseau se situe en régime permanent encadrant un régime de fonctionnement transitoire du réseau.

La détection du régime permanent du réseau s'effectue à l'aide du calcul de la dérivée de la tension homopolaire et comparaison de cette dérivée avec des seuils de détection Sp et St, comme mentionné précédemment.

Lors de l'étape 28 suivante, on vérifie que l'on dispose effectivement des fenêtres de début et de fin d'acquisition.

Si tel n'est pas le cas, la procédure retourne à l'étape 26 précédente.

Si tel est le cas, au cours de l'étape 30 suivante, le dispositif de détection 16 procède à un calcul de la variation de la tension homopolaire $V_o$ et du courant de neutre $I_N$ entre les fenêtres de début et de fin, selon les relations suivantes :

$$\Delta V_o = V_{OFf} - V_{OFd} \qquad (2)$$

$$\Delta I_N = I_{NFf} - I_{NFd} \qquad (3)$$

Si le module de $\Delta V_o$, ainsi calculé, est supérieur à une valeur de seuil $S_{\Delta V_o}$ (étape 32), le retard η de phase à appliquer au vecteur de courant de neutre pour élaborer le plan complexe est calculé, au cours de l'étape 34 suivante selon la relation suivante :

$$\eta = \arg\left[\Delta I_N . \text{conjugué}(\Delta V_o)\right] - \frac{\pi}{2} \qquad (4)$$

C'est à dire, le retard η est calculé comme étant le déphasage de $\Delta I_N$ par rapport à $\Delta V_o$ moins $\frac{\pi}{2}$.

Lors de l'étape 36 suivante, le retard η ainsi calculé est mémorisé et le dispositif de détection 16 procède à l'élaboration proprement dite du plan complexe servant à la détection des défauts résistants.

Au contraire, si lors de l'étape 32 précédente, il est déterminé que la valeur calculée $\Delta V_o$ est inférieure à la valeur de seuil $S_{\Delta V_o}$, le calcul du retard η n'est pas effectué.

On notera que le seuil $S_{\Delta V_o}$ constitue un seuil réglable. Il a par exemple une valeur égale à 100 Volts pour un réseau de 20 kV.

On notera également que la définition des fenêtres d'acquisition de début et de fin, qui correspondent toutes deux à un fonctionnement en régime permanent, s'effectue de telle manière que les deux instants d'acquisition des données correspondent respectivement à une acquisition de données avant l'apparition d'un défaut et une acquisition de données après apparition d'un défaut et ce, après que le régime de fonctionnement redevienne permanent.

Pour ce faire, en référence à la figure 4, pour la détermination des fenêtres d'acquisition sur lesquelles l'angle η est déterminé, c'est-à-dire l'angle correspondant au retard à appliquer à l'expression de $I_N$ afin de déterminer le plan complexe, lors d'une première étape 38, on procède à une analyse de données acquises dans deux fenêtres temporelles successives N-1 et N.

Dans l'étape 40 suivante, on détermine si la dérivée de la tension homopolaire par rapport au temps est supérieure à la valeur $S_p$ de seuil de détection de régime de fonctionnement permanent.

Si tel n'est pas le cas, lors de l'étape 42 suivante, on procède à une mémorisation de la fenêtre d'acquisition N. On procède ensuite à une incrémentation (étape 44) de manière à procéder à une analyse sur des fenêtres suivantes N et N+1.

Au contraire, si tel est le cas, lors de l'étape 46 suivante, on procède à une mémorisation de la fenêtre précédente N-1, que l'on considère comme étant une fenêtre de début.

Lors de l'étape 48 suivante, on procède à une analyse sur les fenêtres suivantes N et N+1 et l'on détermine si la dérivée par rapport au temps de la tension homopolaire est supérieure au seuil $S_t$ de détection de régime de fonctionnement transitoire (étape 50).

Si tel n'est pas le cas, lors d'une étape 52 ultérieure, on détermine si la dérivée par rapport au temps de la tension homopolaire acquise au cours des fenêtres d'acquisition N et N+1 est supérieure au seuil de détection $S_p$ de régime de fonctionnement permanent:

Si tel n'est pas le cas, la procédure retourne à l'étape 38 précédente.

Si tel est le cas, on procède à une étape d'incrémentation de manière à effectuer une analyse sur les fenêtres suivantes (étape 54).

Dans le cas où, lors de l'étape 50 il est déterminé que la dérivée de la tension homopolaire par rapport au temps, entre les fenêtres N et N+1 est supérieure au seuil $S_t$, lors de l'étape 56 suivante, on procède à une étape d'incrémentation de manière à procéder à une analyse sur les fenêtres suivantes (étape 58).

On procède alors, lors d'une étape 60 ultérieure, à un calcul de la dérivée de la tension homopolaire entre ces fenêtres pour détecter si cette dérivée est inférieure à la valeur de seuil $S_p$ de détection de régime de fonctionnement permanent.

Si tel n'est pas le cas, la procédure retourne à l'étape 56 précédente de manière à procéder à une analyse sur les fenêtres suivantes.

Au contraire, si tel est le cas, c'est-à-dire si il a été détecté que le réseau se situe en régime permanent, on procède à la mémorisation de la fenêtre N en tant que fenêtre de fin (étape 62).

La procédure qui vient d'être décrite permet de procéder à une acquisition de données à l'intérieur de fenêtres d'acquisition correspondant à un régime de fonctionnement permanent du réseau se situant de part et d'autre d'une plage de fonctionnement en régime transitoire.

En se référant à nouveau à la figure 2, après calcul du retard η à appliquer par rapport au vecteur représentatif du courant de neutre $I_N$ mesuré, le dispositif de détection 16 procède à une élaboration de la zone de détection Z, hachurée sur cette figure 2.

Comme on le voit sur cette figure, cette zone de détection est délimitée par deux droites DI et DII, ainsi que par une portion de cercle C de rayon égal au seuil des dispositifs de protection.

Les coordonnées $y_1$ et $y_2$ des droites DI et DII sont respectivement définies selon les relations suivantes :

$$y_1 = -\frac{x + \text{seuil}}{\text{tg}(\theta)} \qquad (5)$$

$$y_2 = \frac{x - \text{seuil}}{\text{tg}(\theta)} \qquad (6)$$

dans lesquelles θ représente une valeur de compensation d'erreurs de mesure, c'est-à-dire d'erreurs correspondant à la somme des erreurs sur le courant résiduel mesuré, sur le calcul du retard η et sur la mesure de $I_N$.

Par ailleurs, le plan complexe et la zone de détection Z ayant été élaborés, le dispositif de détection 16 procède, comme mentionné précédemment, au positionnement du point de fonctionnement de la ligne de départ, défini à partir du courant résiduel mesuré et à une analyse de la coïncidence entre le point de fonctionnement et la zone de détection pour décider si cette coïncidence correspond à une détection d'un défaut nécessitant un actionnement des dispositifs de protection, et ce en fonction du régime de fonctionnement du réseau , à savoir permanent ou transitoire.

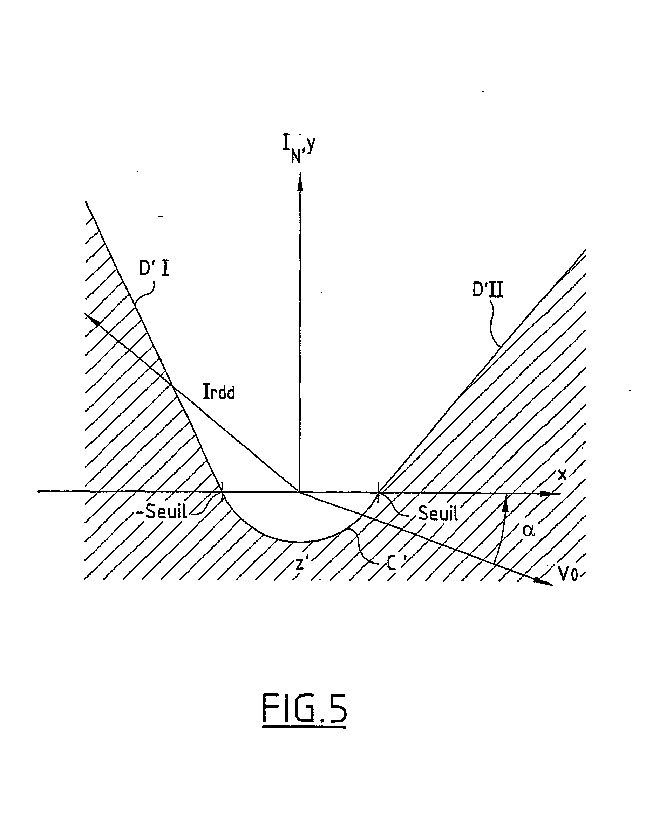

Dans le cas où le calcul du retard η à appliquer à la mesure du courant de neutre n'est pas possible, en particulier dans le cas où la valeur de $\Delta V_o$ est inférieure à la valeur de seuil $S_{\Delta V_o}$ ou au cours d'une phase de réglage de la bobine de compensation 24, le dispositif de détection 16 utilise un plan complexe de secours , visible sur la figure 5.

Ce plan complexe de secours est également utilisé dans le cas où aucun calcul de η n'a été effectué, ou si la bobine de compensation a changé de point de fonctionnement c'est-à-dire si la valeur de η n'est plus valide. Il est utilisé en attendant de disposer d'une valeur η.

Contrairement au plan complexe visible sur la figure 2, qui est utilisé lors du fonctionnement normal du dispositif 16, l'axe des imaginaires du plan complexe de secours coïncide avec le vecteur représentatif du courant de neutre $I_N$. En d'autres termes, ce plan correspond à une valeur de η égale zéro.

Comme on le voit sur la figure 5, la zone de détection Z' est délimitée par deux droites D'I, D'II et par un cercle C' de rayon égal au seuil des dispositifs de protection.

Les coordonnées $y_1$ et $y_2$ des droites D'I et D'II correspondent respectivement aux relations suivantes :

$$y_1 = -\frac{x + \text{seuil}}{\text{tg}(\theta - \alpha)} \qquad (7)$$

$$y_2 = \frac{x - \text{seuil}}{\text{tg}(\theta + \alpha)} \qquad (8)$$

dans lesquelles :

seuil désigne le seuil des dispositifs de protection ;
θ correspond à une compensation introduite pour corriger l'erreur de phase
globale introduite par les organes d'acquisition ; et
α correspond à un déphasage entre l'axe des réelles du plan complexe et la valeur $V_o$ de la tension homopolaire théorique, l'erreur de phase globale correspondant à la somme des modules de l'erreur de phase sur l'acquisition du courant de neutre $I_N$ et sur l'acquisition du courant résiduel du départ à protéger.

Après définition de ce plan complexe de secours et élaboration de la zone de détection Z', le dispositif de détection 16 procède comme précédemment, c'est à dire qu'il positionne le point de fonctionnement de la ligne de départ à surveiller en vue de la détection d'un défaut résistant en fonction du régime de fonctionnement du réseau.

Contrairement au plan complexe principal, le plan complexe de secours est fonction du déphasage entre l'axe des réels et la tension homopolaire théorique. Ce déphasage $\alpha$ est variable en fonction de la position de l'impédance de compensation mais n'est pas une variable connue par le dispositif de détection. Il constitue une variable réglable.

On notera que le dispositif de détection de défauts conforme à l'invention est doté de plusieurs sorties de détection de défauts, dont l'une correspond à une sortie de détection certaine, sans temporisation associée dont l'une, dite de régime spécial d'exploitation, est associée à une temporisation $T_1$ réglable et dont l'une, dite de «déclenchement», est associée à une temporisation $T_2$ réglable.

Le temps de fonctionnement du dispositif de détection est variable suivant la sortie considérée. Ce temps de fonctionnement est égal au réglage des temporisations $T_1$ et $T_2$, respectivement pour les sorties de régime spécial d'exploitation et de « déclenchement ».

Les temporisations $T_1$ et $T_2$ sont activées lorsqu'il a été détecté une coïncidence entre le point de fonctionnement et la zone de détection, en régime permanent.

Ces sorties temporisées passent de 0 à 1 à l'échéance de leur temporisation respective $T_1$, $T_2$ moins le temps de montée « T » du dispositif de détection, c'est-à-dire le temps mis par le dispositif pour détecter un défaut.

Ce temps de montée est compté à partir de l'instant d'apparition du défaut, c'est-à-dire lors du passage du régime permanent en régime transitoire. Les temporisations $T_1$ et $T_2$ sont ensuite remises à 0 lors du passage du dispositif de détection de 1 à 0.

En fonction du comportement du défaut (défaut instable), le temps de montée « T » du dispositif de détection peut devenir supérieur aux temporisations $T_1$ et $T_2$.

Dans ce cas, pour la sortie de régime spécial d'exploitation, si $T \geq T_1$, cette sortie passe instantanément de 0 à 1 au passage à 1 de la sortie correspondante du dispositif de détection.

Pour la sortie dite de « déclenchement », si $T \geq T_2$, la sortie dite de « déclenchement » passe de 0 à 1 à l'expiration d'une durée de $T_2/k$ à compter du passage à 1 de la sortie du dispositif de détection, k étant un paramètre $\geq 1$.

## Revendications

1. Procédé de détection de défauts résistants dans une ligne de départ d'un réseau de distribution d'énergie électrique doté d'une bobine de compensation, à partir d'une mesure du courant résiduel circulant dans cette ligne, **caractérisé en ce qu'**il comporte les étapes consistant à :

  - déterminer la phase de la tension homopolaire ($V_o$) d'un jeu de barres (14) alimentant la ligne de départ,
  - élaborer, à partir de la phase de la tension homopolaire ($V_o$), un plan complexe,
  - délimiter, dans le plan complexe, des zones de fonctionnement (Z ; Z') correspondant à une détection d'un défaut résistant et à une absence de détection d'un défaut,
  - positionner, dans le plan complexe, un point de fonctionnement de la ligne de départ, défini à partir du courant résiduel mesuré, et
  - analyser le régime de fonctionnement du réseau pour décider si la coïncidence entre le point de fonctionnement et une zone de détection correspond à une détection d'un défaut.

2. Procédé selon la revendication 1, **caractérisé en ce que** la phase de la tension homopolaire ($V_o$) est élaborée à partir d'une mesure des variations du courant de neutre ($I_N$) du réseau et de la tension homopolaire ($V_o$),

3. Procédé selon l'une des revendications 1 et 2, **caractérisé en ce que** les grandeurs mesurées du réseau sont mesurées en utilisant des fenêtres temporelles glissantes de durée et de période égales à l'inverse de la fréquence de l'énergie électrique fournie par le réseau.

4. Procédé selon la revendication 3, **caractérisé en ce que** les grandeurs mesurées sont acquises dans des fenêtres temporelles correspondant à un régime de fonctionnement permanent du réseau et situées de part et d'autre d'uné plage de fonctionnement en régime transitoire.

5. Procédé selon l'une quelconque des revendications 1 à 4, **caractérisé en ce qu'**au cours de l'analyse du régime de fonctionnement du réseau, on détermine si le réseau se situe en régime transitoire ou en régime permanent, pour décider, d'une part, que si le régime est permanent, une coïncidence entre le point de fonctionnement et la zone de détection (Z ; Z') correspond à une détection d'un défaut et, d'autre part, lorsqu'une détection est réalisée si le régime devient transitoire, ou si le point de fonctionnement quitte la zone de détection, la détection de défaut est maintenue pendant une période de temps prédéterminée, et que si à l'issue de cette période de temps, le régime du réseau est transitoire ou le point de fonctionnement se situe en dehors de la zone de détection, la détection n'est plus maintenue.

6. Procédé selon les revendications 4 et 5, **caractérisé en ce que** le régime de fonctionnement du réseau est déterminé à partir d'un calcul de la dérivée de la tension homopolaire et comparaison de la dérivée calculée avec des seuils de détection (Sp, St) de régime permanent et de régime transitoire.

7. Procédé selon l'une quelconque des revendications 3 à 6, **caractérisé en ce que** l'axe des réels (x) du plan complexe correspond au vecteur de la tension homopolaire ($V_o$) déduit de l'axe des imaginaires, et **en ce que** l'axe des imaginaires (y) du plan complexe correspond au vecteur du courant de neutre ($I_n$) décalé d'un angle (η) élaboré à partir du déphasage entre la variation du courant de neutre et de la tension homopolaire entre deux mesures acquises pendant le régime de fonctionnement permanent encadrant un régime de fonctionnement transitoire.

8. Procédé selon la revendication 7, **caractérisé en ce que** la zone de détection est délimitée par deux droites dont les coordonnées $x_1$, $y_1$ et $x_2$, $y_2$, sont respectivement déterminées par les relations :

$$y_1 = -\frac{x + \text{seuil}}{\text{tg}(\theta)}$$

$$y_2 = \frac{x - \text{seuil}}{\text{tg}(\theta)}$$

dans lesquelles :

seuil représente un seuil de protection ; et
θ représente une valeur de compensation d'erreurs de mesure,
et par une portion de cercle (C) de rayon égal au seuil de protection.

9. Procédé selon la revendication 6, dépendante de la revendication 3, **caractérisé en ce que** l'axe des imaginaires du plan complexe est en phase avec le vecteur représentatif du courant de neutre ($I_N$).

10. Procédé selon la revendication 9, **caractérisé en ce que** la zone de détection est délimitée par deux droites dont les coordonnées x, $y_1$ et x, $y_2$ sont respectivement définies par les relations suivantes :

$$y_1 = -\frac{x + \text{seuil}}{\text{tg}(\theta - \alpha)}$$

$$y_2 = \frac{x - \text{seuil}}{\text{tg}(\theta + \alpha)}$$

dans lesquelles :

seuil représente un seuil de protection,
θ représente une valeur de compensation d'erreurs de mesure, et
α représente.le déphasage entre l'axe des réelles et la tension homopolaire théorique,
et par une portion de cercle (C') de rayon égal au seuil de protection.

**Claims**

1. Method for detecting resistance faults in an output line of an electrical distribution network fitted with a compensating coil on the basis of a measurement of the residual current circulating in this line, **characterised in that** it comprises the steps of:

    • determining the homopolar voltage phase ($V_o$) of a busbar (14). supplying the output line,
    • preparing a complex plan on the basis of the homopolar voltage phase ($V_o$),
    • defining in the complex plan zones of operation (Z; Z') corresponding to a resistance fault detection and to no fault detection,
    • positioning in the complex plan a point of operation of the output line defined on the basis of the measured residual current, and
    • analysing the operating status of the network to determine whether the coincidence between the point of operation and a detection zone corresponds to a fault detection.

2. Method according to Claim 1, **characterised in that** the homopolar voltage phase ($V_o$) is worked out on the basis of a measurement of the variations in the neutral current ($I_N$) of the network and the homopolar voltage ($V_o$).

3. Method according to one of Claims 1 and 2, **characterised in that** the measured magnitudes of the network are measured by using sliding time windows of equal duration and period inversely to the frequency of the electrical energy supplied by the network.

4. Method according to one of Claim 3, **characterised in that** the magnitudes measured are acquired in time windows corresponding to a permanent operating status of the network and situated on either side of a range of operation in transient status.

5. Method according to any one of Claims 1 to 4, **characterised in that** during the analysis of the operating status of the network, it is determined whether the network is in transient status or permanent status in order to determine, on the one hand, if the status is permanent, that a coincidence between the point of operation and the detection zone (Z; Z') corresponds to a fault detection, and, on the other hand, when a detection is made, if the status remains transient or if the point of operation leaves the detection zone, that the fault detection is maintained during a predetermined period of time, and that if at the end of this period of time the status of the network is transient or the point of operation is located outside the detection zone, the detection is no longer maintained.

6. Method according to Claims 4 and 5, **characterised in that** the operating status of the network is determined on the basis of a calculation of the differential of the homopolar voltage and comparison of the differential calculated with detection thresholds (Sp, St) of the permanent status and transient status.

7. Method according to any one of Claims 3 to 6, **characterised in that** the axis of the real values (x) of the complex plan corresponds to the vector of the homopolar voltage ($V_0$) deduced from the axis of imaginary values, and **in that** the axis of imaginary values (y) of the complex plan corresponds to the vector of the neutral current ($I_N$) shifted by an angle ($\eta$) worked out on the basis of the phase shift between the variation in the neutral current and the homopolar voltage between two measurements acquired during the permanent operating status encompassing a transient operating status.

8. Method according to Claim 7, **characterised in that** the detection zone is defined by two straight lines, of which the coordinates $x_1$, $y_1$ and $x_2$, $y_2$ are determined respectively by the equations:

$$y_1 = -\frac{x + threshold}{tg(\theta)}$$

$$y_2 = \frac{x - threshold}{tg(\theta)}$$

wherein:

threshold represents a protection threshold; and
$\theta$ represents a compensation value for measurement errors,

and by a section of a circle (C) with a radius equal to the protection threshold.

9. Method according to Claim 6 dependent on Claim 3, **characterised in that** the axis of imaginary values of the complex plan is in phase with the vector representing the neutral current ($I_N$).

10. Method according to Claim 9, **characterised in that** the detection zone is defined by two straight lines, of which the coordinates x, $y_1$ and x, $y_2$ are defined respectively by the following equations:

$$y_1 = -\frac{x + threshold}{tg(\theta - \alpha)}$$

$$y_2 = \frac{x - threshold}{tg(\theta + \alpha)}$$

wherein:

threshold represents a protection threshold; and
$\theta$ represents a compensation value for measurement errors, and
$\alpha$ represents the phase shift between the axis of real values and the theoretical homopolar voltage,
and by a section of a circle (C) with a radius equal to the protection threshold.

**Patentansprüche**

1. Verfahren zum Erfassen von Widerstandsfehlern in einer Leitung, die von einem elektrischen Energieverteilungsnetz abgeht, das mit einer Kompensationswicklung versehen ist, und zwar ausgehend von der Messung des Reststromes, der in dieser Leitung fließt, **dadurch gekennzeichnet, dass** es Schritte umfasst, die darin bestehen, dass

- die Phase der gleichpoligen Spannung ($V_0$) eines Sammelschienensystems (14) bestimmt wird, das die abgehende Leitung versorgt,
- ausgehend von der Phase der gleichpoligen Spannung ($V_0$) eine komplexe Ebene erstellt wird,
- in der komplexen Ebene Betriebszonen (Z, Z') begrenzt werden, die einer Erfassung eines Widerstandsfehlers und einem Fehlen eines Widerstandsfehlers entsprechen,
- in der komplexen Ebene ein Betriebspunkt der abgehenden Leitung positioniert wird, der ausgehend vom gemessenen Reststrom bestimmt wird, und
- die Betriebsverhältnisse des Netzes analysiert werden, um zu entscheiden, ob die Übereinstimmung zwischen dem Funktionspunkt und einer Erfassungszone einer Fehlererfassung entspricht.

2. Verfahren nach Anspruch 1, **dadurch gekennzeichnet, dass** die Phase der gleichpoligen Spannung ($V_0$) ausgehend von einer Messung der Änderung des Nullleiterstromes ($I_N$) des Netzes und der gleichpoligen Spannung ($V_0$) gebildet wird.

3. Verfahren nach Anspruch 1 und 2, **dadurch gekennzeichnet, dass** die Messwerte des Netzes **dadurch** gemessen werden, dass Zeitfenster mit gleitender Dauer und Periode gleich dem Kehrwert der Frequenz der elektrischen Energie verwandt werden, die vom Netz geliefert wird.

4. Verfahren nach Anspruch 3, **dadurch gekennzeichnet, dass** die Messwerte in Zeitfenstern gewonnen werden, die einem Dauerbetrieb des Netzes entsprechen und sich auf beiden Seiten eines Übergangsbetrieb befinden.

5. Verfahren nach einem der Ansprüche 1 bis 4, **dadurch gekennzeichnet, dass** im Verlauf der Analyse der Betriebsverhältnisse des Netzes bestimmt wird, ob sich das Netz im Übergangsbetrieb oder im Dauerbetrieb befindet, um einerseits dann, wenn der Betrieb der Dauerbetrieb ist, zu entscheiden, dass eine Übereinstimmung zwischen dem Betriebspunkt und der Erfassungszone (Z, Z') einer Fehlererfassung entspricht, und andererseits dann, wenn eine Erfassung im Übergangsbereich erfolgt oder der Betriebspunkt die Erfassungszone verlassen hat, zu entscheiden, die Erfassung des Fehlers über ein bestimmtes Zeitintervall weiterzuführen und dann, wenn nach diesem Zeitintervall die Betriebsverhältnisse Übergangsverhältnisse sind oder sich der Betriebspunkt außerhalb der Erfassungszone befindet, die Erfassung nicht mehr weiterzuführen.

6. Verfahren nach Anspruch 4 und 5, **dadurch gekennzeichnet, dass** die Betriebsverhältnisse des Netzes ausgehend von der Berechnung des Differenzialquotienten der gleichpoligen Spannung und einem Vergleich des berechneten Differenzialquotienten mit Erfassungsschwellenwerten (Sp, St) des Dauerbetriebs und des Übergangsbetriebs bestimmt wird.

7. Verfahren nach einem der Ansprüche 3 bis 6, **dadurch gekennzeichnet, dass** die reale Achse (x) der komplexen Ebene einem Vektor der gleichpoligen Spannung ($V_0$) abgeleitet von der imaginären Achse entspricht, und dass die imaginäre Achse (y) der komplexen Ebene einem Vektor des Nullleiterstromes ($I_n$) verschoben um einen Winkel ($\eta$) entspricht, der aus der Phasenverschiebung zwischen der Änderung des Nullleiterstromes und der gleichpoligen Spannung zwischen zwei Messungen gebildet wird, die während des Dauerbetriebs gewonnen werden, der einen Übergangsbetrieb einrahmt.

8. Verfahren nach Anspruch 7, **dadurch gekennzeichnet, dass** die Erfassungszone von zwei Geraden begrenzt ist, deren Koordinaten $x_1$, $y_1$ und $x_2$, $y_2$ jeweils durch die folgenden Gleichungen bestimmt sind:

$$y_1 = -\frac{x + \text{Schwellenwert}}{tg(\theta)}$$

$$y_2 = \frac{x - \text{Schwellenwert}}{tg(\theta)}$$

wobei
der Schwellenwert einen Schutzschwellenwert wiedergibt und
$\theta$ einen Wert der Kompensation von Messfehlern wiedergibt und zwar von einem Segment eines Kreises (C) mit einem Radius gleich dem Schutzschwellenwert.

9. Verfahren nach Anspruch 6 und dieser nach Anspruch 3, **dadurch gekennzeichnet, dass** die imaginäre Achse der komplexen Ebene gleichphasig mit dem Vektor ist, der den Nullleiterstrom ($I_N$) wiedergibt.

10. Verfahren nach Anspruch 9, **dadurch gekennzeichnet, dass** die Erfassungszone von zwei Geraden begrenzt ist, deren Koordinaten x, $y_1$ und x, $y_2$ jeweils durch die folgenden Gleichungen bestimmt sind:

$$y_1 = -\frac{x + \text{Schwellenwert}}{tg(\theta - \alpha)}$$

$$y_2 = \frac{x - \text{Schwellenwert}}{\text{tg}(\theta + \alpha)}$$

wobei
der Schwellenwert einen Schutzschwellenwert wiedergibt,
$\theta$ ein Kompensationswert der Messfehler ist und
$\alpha$ die Phasenverschiebung zwischen der realen Achse und der theoretischen gleichpoligen Spannung ist und zwar von einem Segment eines Kreises (C') mit einem Radius gleich dem Schutzschwellenwert.

## FIG.1

* courant résiduel

## FIG.2

FIG.3

FIG.4

FIG.5